# EUROPEAN PATENT APPLICATION

(11) **EP 4 745 667 A1**
(43) Date of publication of application: **20.05.2026**
(21) Application number: 24213502.8
(22) Date of filing: 18.11.2024
(51) Int. Cl.: G03F 7/00, H01L 21/18

(54) **DIE DEFORMATION USING PHASE CHANGE MATERIALS**

(71) Applicant: ASML Netherlands B.V., 5500 AH Veldhoven (NL)
(72) Inventor: BEUKMAN, Arjan, Johannes, Anton, 5500 AH Veldhoven (NL)
(74) Representative: ASML Netherlands B.V.

(57) **Abstract**

Disclosed is a method of deforming a first patterned substrate or one or more first substrate portions thereof, configured to be bonded to a second patterned substrate, the method comprising providing at least said first patterned substrate or one or more first substrate portions thereof with a layer comprising a material that changes its phase when exposed to a radiation; and irradiating the layer with the radiation, wherein the radiation imposes a stress within the first patterned substrate or one or more first substrate portions thereof, the stress causing deformation of the first patterned substrate or one or more first substrate portions thereof that at least partially corrects a position error of a pattern of the first patterned substrate or one or more first substrate portions thereof.

## Description

### BACKGROUND

### Field of the Invention

The present invention relates to a method and apparatus for semiconductor device manufacturing and in particular to a method of deforming a first patterned substrate or one or more first substrate portions thereof, configured to be bonded to a second patterned substrate.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer.

In die-to-wafer bonding, individual dies or chiplets are bonded to an acceptor wafer or substrate. Die-to-wafer bonding is used in heterogeneous 3D integration, which means that multiple chips or dies are bonded on a wafer. These dies can have multiple different data processing and/or storage functionalities and different dimensions.

Die-to-wafer bonding (or wafer to wafer bonding) requires a high degree of lateral placement accuracy to improve the electrical connection between electrical contacts (i.e. to ensure the contacts are accurately aligned). Similarly, die stacking (i.e. the process of mounting multiple chips on top of one another within a single semiconductor package to achieve greater functionality) is also known to require a high degree of lateral placement accuracy for the same reason.

For lateral placement accuracies of less than 100nm, the internal die deformation (or internal wafer deformation) needs to be corrected. However, die-to-wafer bonding tools (and wafer to wafer bonding tools) do not correct for any internal die deformation.

In lithography, it is known to place compensation stress layers at the back side of the patterned dies (or patterned wafers) to substantially reduce the internal (i.e. in-plane) deformations.

In the die-to-wafer bonding process (and the wafer to wafer bonding process, or die stacking process), it would be advantageous to allow dies (or wafers) from various semiconductor manufacturing fabricators to be bonded to a substrate. A challenge associated with this approach is that pre-correction, using lithography processes, may be difficult. In addition, pre-correction using a patterned strained layer may also pose difficulties.

It is desirable to improve the die-to-wafer bonding process (or the wafer to wafer bonding process, or the die stacking bonding process). In particular, it is desirable to deform the die (or wafer) when clamped on a bond-head, just before the die (or wafer) is bonded to the acceptor wafer (or to another die in the case of die stacking).

Herein it should be understood by the skilled reader that when referring to die to wafer bonding, this may also be applied to wafer to wafer bonding or die to die bonding (i.e. die stacking).

### SUMMARY OF THE INVENTION

In a first aspect of the invention, there is provided a method of deforming a patterned die or a patterned wafer, configured to be bonded to another wafer or another die. The method comprising: providing the patterned die or the patterned wafer with a layer comprising a material that changes its phase when exposed to a radiation; and irradiating the layer with the radiation, wherein the radiation imposes a stress within the patterned die or the patterned wafer, the stress causing deformation of the patterned die or the patterned wafer that at least partially corrects a position error of the pattern of the patterned die or the pattern of the patterned wafer.

In a second aspect of the present disclosure, there is provided a bonding tool being operable to perform the method of the first aspect, or any optional embodiments of the first aspect.

In a third aspect of the present disclosure, there is provided an alignment station being operable to perform the method of the first aspect, or any optional embodiments of the first aspect.

In a fourth aspect of the present disclosure, there is provided a lithographic apparatus comprising the alignment station in accordance with the third aspect of the present disclosure.

In a fifth aspect of the present disclosure, there is provided a computer program comprising program instructions operable to perform the method of the first aspect, or any optional embodiments of the first aspect.

In a sixth aspect of the present disclosure, there is provided a non-transient computer-readable storage medium carrying the computer program in accordance with the fifth aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
- Figure 1 depicts a lithographic apparatus together with other apparatuses forming a production facility for semiconductor devices; and
- Figure 2 illustrates a die-to-wafer bonded substrate.
- Figure 3 depicts a method in accordance with a first aspect of the present disclosure.
- Figure 4 depicts a schematic diagram of an alignment station adapted to include an irradiation source in accordance with the first aspect.
- Figure 5 depicts a schematic of a bonding tool adapted to include an irradiation source in accordance with the first aspect.

### DETAILED DESCRIPTION

Before describing embodiments of the invention in detail, it is instructive to present an example environment in which embodiments of the present invention may be implemented.

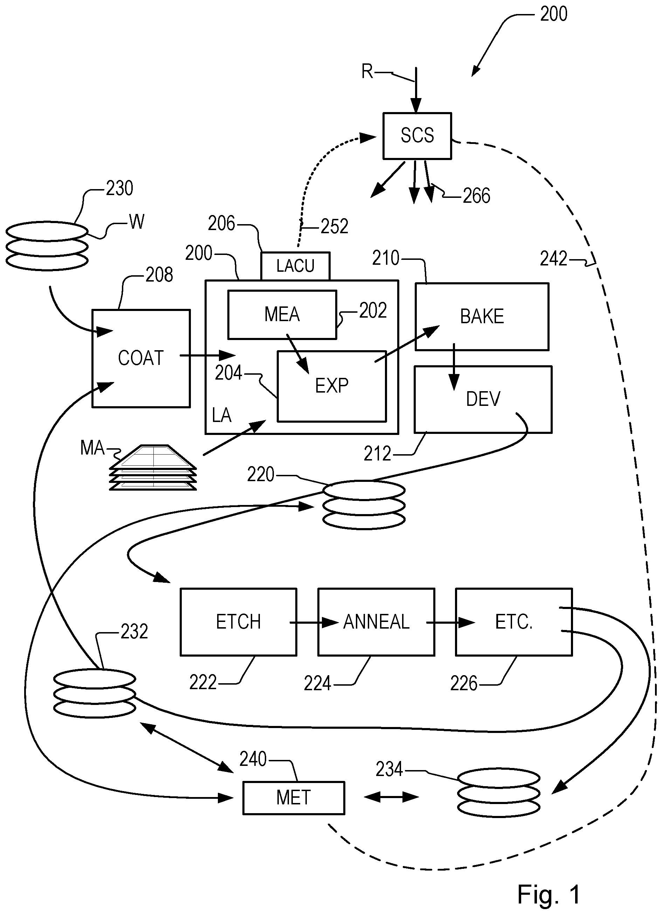

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and substrate optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

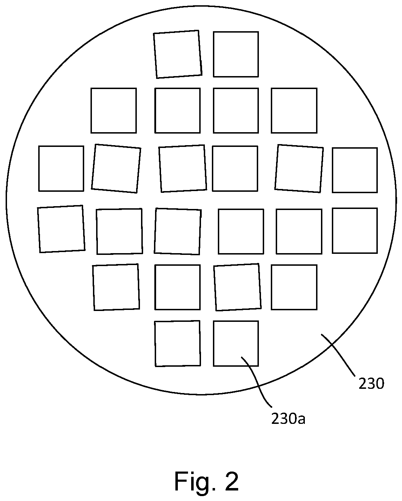

Figure 2 depicts a substrate 230 (i.e. a wafer) with a number of sub-portions 230a (i.e. dies) which are bonded to the substrate 230.

Die-to-wafer bonding or wafer-to-wafer bonding comprises using a bonding tool to bond a number of individual dies (first substrate portions) or a wafer (first substrate) to an acceptor or base wafer (second substrate), e.g., to provide a heterogeneous 3D integration of the individual dies or another wafer onto the acceptor wafer. The dies, for example, may have multiple different data processing and/or storage functionalities and different dimensions.

It is important to properly align the patterns of the individual dies or first wafer to the patterns of the acceptor wafer such that they properly connect and function properly. There are two complementary methods which may be used to achieve this. Firstly, corrections may be made during the actual exposure of the top layers. These corrections may be based on alignment metrology and/or bonding overlay metrology (i.e., measuring the alignment of the respective top bonding layers of the bonded wafer). Additionally, further correction may be implemented during the bonding process itself e.g., via wafer positioning and/or deformation implemented by the bonding tool. However, bonding tool correction is typically quite limited compared to lithography tool correction.

The concepts disclosed herein aim to improve relative alignment of the respective top layers of the dies or a first wafer and an acceptor wafer as part of a wafer bonding process.

A particular cause of alignment errors of the respective top layers is internal deformation or in-plane deformation of the dies or wafers. Particularly in the example of die-to-wafer bonding, the dies being bonded may be made by different semiconductor fabricators, making it particularly difficult to effect the appropriate corrections during the lithography steps. Therefore, the concepts disclosed herein aim to improve the aforementioned relative alignment of the respective top layers post-exposure.

The internal deformations may be measured using an alignment grid by reference to which the patterns are positioned. In regular lithography, the aforementioned alignment techniques determine the alignment grid by reference to which the patterns are positioned. The alignment grid is modeled at wafer level (interfield) and field level (intra-field). This means that by measuring the deformation on a sub-sampled number of locations on the wafer, the complete wafer deformation can be modelled, depending on the nature of the deformation and the model used to describe it. For example, a single field (or a field per region) may be measured densely and an intra-field model fitted, with the remaining fields being measured sparsely to determine an interfield model.

Regular lithography alignment, as described above, is typically performed in three steps. A first step may comprise pre-alignment step, during which a first set of alignment marks (coarse alignment marks) are found. When the coarse alignment marks have been found, a coarse alignment step is performed to find a second set of alignment marks (fine alignment marks). Finally, a fine alignment step measures the fine alignment marks to determine their position from which the aforementioned grid is determined.

It is proposed herein to provide an improved method for correcting for internal deformations which cannot be easily corrected for during the photolithography process, for example when a plurality of dies are used from more than one semiconductor fabricator, thereby making it difficult or impossible to properly correct for these deformations during the photolithography process.

As such, a method is proposed of deforming a first patterned substrate or one or more first substrate portions thereof, configured to be bonded to a second patterned substrate. The method comprising: providing at least said first patterned substrate or one or more first substrate portions thereof with a layer comprising a material that changes its phase when exposed to a radiation; and irradiating the layer with the radiation, wherein the radiation imposes a stress within the first patterned substrate or one or more first substrate portions thereof, the stress causing deformation of the first patterned substrate or one or more first substrate portions thereof that at least partially corrects a position error of a pattern of the first patterned substrate or one or more first substrate portions thereof.

In one example, the correction for internal deformations of the die (or the wafer) may be applied before bonding. In particular, the skilled reader would understand that deformation of up to 100nm could be corrected using such an approach. The method may comprise applying a phase change stressor layer to a die or wafer to be bonded to an acceptor wafer and selectively irradiating the layer to apply selective deformation to areas (e.g., relating to particular pattern features) of the die or wafer. The selective irradiation may selectively heat or otherwise selectively deform a particular area or areas to effect a change in a pattern feature positions, e.g., such that it will be better aligned with a complementary pattern feature on the wafer to which it is to be bonded.

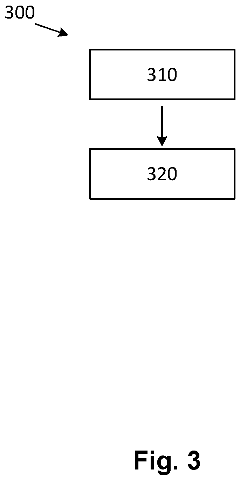

Figure 3 depicts a method of deforming a first patterned substrate or one or more first substrate portions thereof, configured to be bonded to idea second patterned substrate, in accordance with a first aspect of the disclosure. The method 300 comprising: providing 310 at least said first patterned substrate or one or more first substrate portions thereof with a layer comprising a material that changes its phase when exposed to a radiation; and irradiating 320 the layer with the radiation, wherein the radiation imposes a stress within the first patterned substrate or one or more first substrate portions thereof, the stress causing deformation of the first patterned substrate or one or more first substrate portions thereofthat at least partially corrects a position error of a pattern of the first patterned substrate or one or more first substrate portions thereof.

The deformation of the first patterned substrate or first substrate portion comprises in-plane deformation. The in-plane deformation may mean a deformation of the pattern printed on the first patterned substrate or one or more first substrate portions thereof across the planar surface of the first patterned substrate or one or more first substrate portions thereof. The position error may be predefined, for example the position error may have been measured prior to applying the method in accordance with the first aspect of the disclosure. The position error may be a deviation from a plurality of predefined alignment markers measured on the first patterned substrate or first substrate portion.

In accordance with an example as disclosed herein, the step of determining where to irradiate on the layer discussed in relation to the first aspect of the disclosure, may comprise: measuring a grid by measuring positions of pattern features (e.g., alignment marks, overlay targets or other metrology targets) to obtain measurement data; fitting a model to the measurement data; and determining where to irradiate on the layer based on the fitted model. The step of measuring the grid may comprise using an alignment station (e.g. a tool or system designed to measure the alignment grid to reference a lithographic exposure). The fitted model may comprise a linear, polynomial or radial basis function model which is empirically fitted to the measurement data. The step of determining where to irradiate on the layer may comprise irradiating layers which are misaligned by at least a predefined threshold distance (e.g. at least 10nm, at least 20nm, at least 30nm, at least 40nm, at least 50nm, at least 60nm at least 70nm, at least 80nm or at least 90nm, etc.). As such, the corrections may also be based on metrology of the alignment of the bonded layers post-bonding in a feedback process.

In accordance with another example as disclosed herein, the radiation used to irradiate the layer may be configured to heat the layer, and wherein upon absorbing the heat the layer changes phase (i.e. the layer is a phase change material). The radiation may comprise patterned radiation. In an example, the radiation may comprise electromagnetic radiation or a particle beam (from a particle beam source). Where the radiation may comprise a particle beam, the particle beam may comprise an electron beam. The skilled reader would understand that in such an example, the particle beam may require a sufficient vacuum environment to allow propagation of the particles from the particle beam to reduce or prevent attenuation or absorption of the particles from the particle beam.

In accordance with a further example of the present disclosure, the step of irradiating the layer may comprise irradiating a local area of the layer (i.e. a part of the layer which is not the entirety of the layer). By irradiating the local area of the layer, this may induce stress on the local area of the layer and at least partially correcting a position error of the pattern of the first patterned substrate or one or more first substrate portions thereof corresponding to the local area.

In accordance with yet another example of the present disclosure, the step of irradiating the layer with the radiation may be performed before the first patterned substrate or one or more first substrate portions thereof is bonded to the second bonded substrate. Alternatively, in accordance with yet another example of the present disclosure, the step of irradiating the layer with the radiation may be performed after the bonding process has begun but before bonding has taken place. The skilled reader would understand that during the bonding process, the bonding process creates a bonding fingerprint, where the bond induces a stretching of the layers being bonded. This results in a bonding wave propagating across the surface of the layers. Consequently, there is period of time after which the bonding process has begun but before bonding has taken place, while the bond wave is propagating (as the bonding wave moves slowly), where the step of irradiating the layer may still at least partially correct the position error of the pattern of the patterned die or the pattern of the patterned wafer.

In accordance with a further example of the present disclosure, the material that changes its phase when exposed to the radiation may be selected from: GeₓSb_{y}Te_{z} or VO₂. In another example, the layer may be positioned between the patterned die or the patterned wafer and the corresponding other die or other wafer.

In an example, the die may be clamped onto a substrate support or table comprising a plurality of rigid burls or plurality of long flexible burls. Advantageously, using long flexible burls enables the burls (i.e., those burls immediately under a portion of the wafer being irradiated) to move with the induced deformation caused by irradiating the layer.

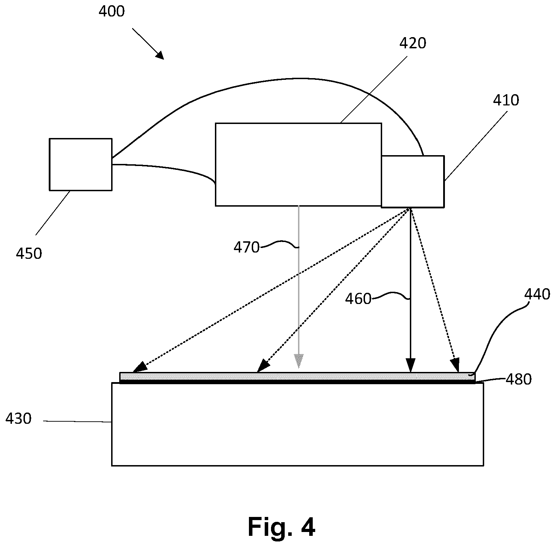

Figure 4 depicts an alignment station 400 in accordance with another aspect of the present disclosure, the alignment station 400 being operable to perform the method in accordance with the first aspect, or the preferred examples of the first aspect.

In particular, the alignment station 400 comprises an irradiation source 410, which is configured to provide a radiation 460 to a wafer 440, and more specifically to a layer 480 comprising a material that changes its phase when exposed to the radiation 460. It is depicted that the radiation 460 may be projected to different local areas of the layer 480. As described elsewhere in this disclosure, this radiation 460 may impose a stress within the wafer 440 (or in a first patterned substrate or one or more first substrate portions thereof). There is also depicted projection optics 420, the projection optics 420 being configured to emit alignment radiation 470 (e.g. optical beams) to determine the alignment of a wafer's position using alignment marks (not shown) on the wafer 440. Both the irradiation source 410 and the projection optics 420 are depicted as being connected to a processing unit 450 configured to control the irradiation source 410 and/or the projection optics 420. The wafer 440 is shown as being held by a clamp 430 (i.e. a wafer table).

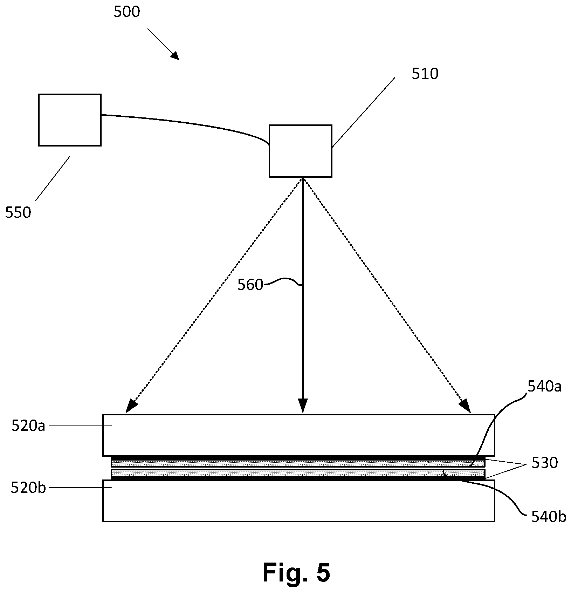

Figure 5 depicts a bonding tool 500 in accordance with another aspect of the present disclosure, the bonding tool 500 being operable to perform the method in accordance with the first aspect, or the preferred examples of the first aspect.

In particular, the bonding tool 500 comprises an irradiation source 510, which is configured to provide radiation 560. The irradiation source 510 is depicted as being connected to a processing unit 550 configured to control the irradiation source 510. The radiation 560 being provided from the irradiation source 510 is directed to at least one of a first wafer 540a or a second wafer 540b. The first wafer 540a is held by a first clamp 520a, and the second wafer 540b is held by a second clamp 520b. A layer 530 is depicted as being part of the first wafer 540a and the second wafer 540b, although in an optional example of the present disclosure, the layer 530 may be part of only one of the first wafer 540a or the second wafer 540b. The layer 530 comprises a material that changes its phase when exposed to the radiation 560. It is depicted that the radiation 560 may be projected to different local areas of the layer 530. As described elsewhere in this disclosure, this radiation 560 may impose a stress within the wafers 540a and/or 540b (herein each of the wafers 540a and 540b are also referred to as a first patterned substrate or one or more first substrate portions thereof).

It can be appreciated that both first wafer and second wafer, or both the dies (first substrate portions) and second wafer may each be provided with the phase change wafer and therefore each irradiated to provide a complementary correction for each wafer.

Further embodiments of the invention are disclosed in the list of numbered clauses below:
1. A method of deforming a first patterned substrate or one or more first substrate portions thereof, configured to be bonded to a second patterned substrate, the method comprising:
   providing at least said first patterned substrate or one or more first substrate portions thereof with a layer comprising a material that changes its phase when exposed to a radiation; and
   irradiating the layer with the radiation, wherein the radiation imposes a stress within the first patterned substrate or one or more first substrate portions thereof, the stress causing deformation of the first patterned substrate or one or more first substrate portions thereof that at least partially corrects a position error of a pattern of the first patterned substrate or one or more first substrate portions thereof.
2. The method of clause 1, wherein the deformation of the first patterned substrate or first substrate portion comprises in-plane deformation.
3. The method of clause 1 or 2, wherein the position error is predefined.
4. The method of clause 3, wherein the predefined position error is a deviation from a plurality of predefined alignment markers measured on the first patterned substrate or first substrate portion.
5. The method of clause 4, wherein determining where to irradiate on the layer comprises:
   - measuring a grid by measuring pattern features to obtain measurement data;
   - fitting a model to the measurement data; and
   - determining where to irradiate on the layer based on the fitted model.
6. The method of any preceding clause, wherein the radiation is configured to heat the layer, and wherein upon absorbing the heat the layer changes phase.
7. The method of any preceding clause, wherein the radiation is patterned radiation.
8. The method of any preceding clause, wherein radiation comprises electromagnetic radiation or a particle beam.
9. The method of clause 8, wherein when the radiation is the particle beam, the particle beam comprises an electron beam.
10. The method of any preceding clause, wherein the irradiating the layer comprises irradiating a local area of the layer thereby inducing the stress on the local area of the layer and at least partially correcting a position error of the pattern of the first patterned substrate or one or more first substrate portions thereofcorresponding to the local area.
11. The method of any preceding clause, wherein the material comprised within the layer is selected from: GeₓSb_{y}Te_{z} or VO₂.
12. The method of any preceding clause, wherein the layer is positioned between first patterned substrate or one or more first substrate portions thereof and the corresponding second patterned substrate.
13. The method of any preceding clause, further comprising clamping said first patterned substrate or one or more first substrate portions thereof onto a plurality of long flexible burls.
14. The method of any preceding clause, wherein said irradiating step comprises locally irradiating the first patterned substrate or one or more first substrate portions thereof to impose a local stress within the first patterned substrate or one or more first substrate portions thereof.
15. The method of any preceding clause, wherein the step of irradiating the layer with the radiation is performed before the first patterned substrate or one or more first substrate portions thereof is bonded to the second bonded substrate.
16. The method of any of clauses 1 to 14, wherein the step of irradiating the layer with the radiation is performed after the bonding process has begun but before bonding has taken place.
17. The method of any preceding clause, comprising bonding of the first patterned substrate or one or more first substrate portions thereof to said second bonded substrate.
18. A bonding tool being operable to perform the method of any of clauses 1 to 17.
19. The bonding tool of clause 18, further comprising an irradiation source configured to irradiate the layers.
20. An alignment station being operable to perform the method of any of clauses 1 to 15.
21. The alignment station of clause 20, further comprising an irradiation source configured to irradiate the layers.
22. A lithographic apparatus comprising the alignment station of clause 20 or 21.
23. A computer program comprising program instructions operable to perform the method of any of clauses 1 to 17, when run on a suitable apparatus.
24. A non-transient computer-readable storage medium carrying the computer program of clause 23.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and substrate optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of deforming a first patterned substrate or one or more first substrate portions thereof, configured to be bonded to a second patterned substrate, the method comprising:
providing at least said first patterned substrate or one or more first substrate portions thereof with a layer comprising a material that changes its phase when exposed to a radiation; and
irradiating the layer with the radiation, wherein the radiation imposes a stress within the first patterned substrate or one or more first substrate portions thereof, the stress causing deformation of the first patterned substrate or one or more first substrate portions thereof that at least partially corrects a position error of a pattern of the first patterned substrate or one or more first substrate portions thereof.

2. The method of claim 1, wherein the deformation of the first patterned substrate or first substrate portion comprises in-plane deformation.

3. The method of claim 1, wherein the position error is predefined.

4. The method of claim 3, wherein the predefined position error is a deviation from a plurality of predefined alignment markers measured on the first patterned substrate or first substrate portion.

5. The method of claim 4, wherein determining where to irradiate on the layer comprises:
- measuring a grid by measuring positions of pattern features to obtain measurement data;
- fitting a model to the measurement data; and
- determining where to irradiate on the layer based on the fitted model.

6. The method of claim 2, wherein the radiation is configured to heat the layer, and wherein upon absorbing the heat the layer changes phase.

7. The method of claim 2, wherein the radiation is patterned radiation.

8. The method of claim 2, wherein radiation comprises electromagnetic radiation or a particle beam.

9. The method of claim 8, wherein when the radiation is the particle beam, the particle beam comprises an electron beam.

10. The method of claim 2, wherein the irradiating the layer comprises irradiating a local area of the layer thereby inducing the stress on the local area of the layer and at least partially correcting a position error of the pattern of the first patterned substrate or one or more first substrate portions thereofcorresponding to the local area.

11. The method of claim 2, wherein the material comprised within the layer is selected from: GeₓSb_{y}Te_{z} or VO₂.

12. The method of claim 1, wherein the layer is positioned between first patterned substrate or one or more first substrate portions thereof and the corresponding second patterned substrate.

13. The method of claim 1, further comprising clamping said first patterned substrate or one or more first substrate portions thereof onto a plurality of long flexible burls.

14. The method of claim 1, wherein said irradiating step comprises locally irradiating the first patterned substrate or one or more first substrate portions thereof to impose a local stress within the first patterned substrate or one or more first substrate portions thereof.

15. The method of claim 1, further comprising bonding of the first patterned substrate or one or more first substrate portions thereof to said second bonded substrate.
